**Europäisches Patentamt**

**European Patent Office**

**Office européen des brevets**

(19)

(11) Publication number : **0 458 471 B1**

(12)

# EUROPEAN PATENT SPECIFICATION

(45) Date of publication of patent specification :
**30.03.94 Bulletin 94/13**

(51) Int. Cl.⁵ : **C09D 4/00**

(21) Application number : **91303828.7**

(22) Date of filing : **26.04.91**

(54) **Low leaching UV curable sealant and encapsulant with post cure mechanism.**

(30) Priority : **17.05.90 US 525359**

(43) Date of publication of application :
**27.11.91 Bulletin 91/48**

(45) Publication of the grant of the patent :
**30.03.94 Bulletin 94/13**

(84) Designated Contracting States :
**DE FR GB IT**

(56) References cited :
**EP-A- 0 110 540**
**US-A- 4 607 084**

(73) Proprietor : **DOW CORNING CORPORATION**
**3901 S. Saginaw Road**
**Midland Michigan 48686-0994 (US)**

(72) Inventor : **Juen, Donnie Ray**
**2502 Peterson Drive**
**Sanford, Michigan (US)**
Inventor : **Thanawalla, Chandrakant**
**Bhagwandas**
**412 Wanetah**
**Midland, Michigan (US)**

(74) Representative : **Horton, Sophie Emma et al**
**Elkington and Fife Prospect House 8**
**Pembroke Road**
**Sevenoaks, Kent TN13 1XR (GB)**

## Description

This invention relates to ultraviolet curable compositions which are useful in the electronics industry.

Materials for the electronics industry need to meet stricter requirements because the electronic devices are becoming smaller and more complex. The field of electrical connectors is no exception. The various coatings require that the materials protect the electronic devices and components from the environments which they may encounter either during processing or in use. A problem which exists with some materials is that they may exhibit one advantageous property while another property will be deficient or by manipulating the formulation of a material to achieve an advantageous property, a new undesirable property is discovered. The applicants were faced with just such a situation when commercializing products for electrical and electronic applications which required flame retardant properties, adhesion properties to poly(phenylene)sulfide substrate and parylene coating and solvent resistance. Ultraviolet radiation curable compositions which the applicants prepared to pass the required flame test, produced an oily film on the substrates and did not adhere well after solvent exposure. We found that we could eliminate fire retardant and still pass the required flamibility test. It was quite unexpectedly found by eliminating fire retardant, a satisfactory encapsulant and coating material for military electronic applications could be obtained.

The present invention provides a composition which cures both by exposure to ultraviolet radiation and by heat and possesses a property profile which meets rigorous environmental conditions during processing and during its useful life as part of a military electronics component or assembly. Of course, many non-military electronic applications may find this composition useful because of its unique properties.

This invention relates to an ultraviolet curable composition consisting essentially of (A) 100 parts by weight of an acrylated urethane oligomer containing an average of from 2 to 3 acryl groups selected from the group consisting of acrylate and methacrylate, said acrylated urethane oligomer being based on aliphatic isocyanate, (B) 50 to 60 parts by weight of hydroxypropylmethacrylate, (C) 3.0 to 3.5 parts by weight of hydroxymethylphenylpropanone, (D) 1.9 to 2.1 parts by weight of 1,1-bis(t-butylperoxy)cyclohexane, and (E) 11 to 12 parts by weight of amorphous silica filler having a surface area of from 150 to 300 square meters per gram.

Another aspect of this invention is related to a cured article comprising a low leaching cured composition obtained by coating or encapsulating a substrate with the composition of claim 1 and exposing the composition to ultraviolet radiation in sufficient intensity and duration to cure the composition. The cured composition is a low leaching material having a low weight loss upon exposure to hot and cold degreasing solvent, which adheres to the substrates both before and after vapor degreasing and passes the UL 94 horizontal burning test (designated UL 94HB test). The UL 94HB test is done according to the procedure described in "Test For Flammability Of Plastic Materials - UL 94", pages 5-7, September 25, 1981.

The compositions of the present invention are curable by exposure to ultraviolet radiation and also can be cured by exposure to heat. The present compositions can be cured by exposure to ultraviolet radiation and still possess the ability to cure by heating, i.e., post curing or shadow curing. The present compositions can be used to coat complex devices in which there are undercuts, i.e. regions or locations where the coating composition will be out of sight of the ultraviolet radiation and thus would remain uncured. However, the compositions of the present invention have the ability to cure via heating and thus the regions or locations which are not exposed to the ultraviolet radiation can be cured by exposure to heat. The amount of heat and the duration of the heating necessary with the present composition is relatively low. The ability to cure the compositions with low amounts of heat is important because many of the electronics materials and construction can be affected by exposure to high temperatures or to heat for long durations. The compositions of the present invention are storable in one package over long periods of time, such as two years or more. The composition can be packaged in a single container and then used without there being any substantial change in the properties of curing or the physical and chemical properties of the cured product. Sometimes a viscosity increase may be observed but with simple shearing, such as by stirring, the viscosity will fall within the acceptable range.

The compositions of the present invention cure to films which pass UL 94HB test required for military electronic applications, produce low leaching films when exposed to hot or cold degreasing solvents and have connector pin hole adhesion to substrates containing at least one connector pin hole after exposure to solvents, especially hot solvents and under autoclave conditions. The compositions can be cured on substrates such as poly(phenylene)sulfide and glass and the cured coatings can be overcoated with parylene which is a high purity protective coating for electronic devices. The cured composition adheres very well to substrates having holes for connector pins. This adhesion even exists after exposure to hot degreasing solvents such as Freon TA, Freon TMC and 1,1,1-trichloroethane. The cured compositions also maintain their adhesion after autoclaving at temperatures of 270°C. for at least 30 minutes.

Military connector backsealing materials are required to adhere to poly(phenylene)sulfide substrates without leaching out unreacted or unreactable ingredients from the cured films, especially when exposed to degreasing solvents during processing. Ingredients leaching out of the cured films can contaminate the solvent bath, cause adhesion failure between the cured films and the substrates especially where the substrate has connector pin holes, cause contamination of electrically functional elements with undesirable changes occurring and can produce unattractive articles. Contamination of the degreasing solvent bath is very undesirable because the contaminates build up in the solvent during processing and the contaminates can deposit on electronic devices being degreased. This deposition of contaminates on the electronic devices interferes with future processing or utility, such as in those situations where the electronic device is to be coated with another material, such as a protective overcoat. In some applications, parylene is to be coated over such cured films and therefore the films require that parylene adhere to it. If the surface of the cured composition is contaminated by the leachate in the degreasing bath, the surface may be difficult to overcoat and cleaning the leachate from the surface may be very expensive as well as damaging to the cured film. Using fresh solvent in the cleaning bath is very expensive and disposal of the contaminated solvent containing the leachate would create a disposal problem. Compositions were unexpectedly found which overcome the problems encountered with previous compositions prepared for such applications. Compositions of the present invention exhibit reduced leaching when exposed to degreasing solvents, including hot degreasing solvents and the adhesion is acceptable under many conditions as discussed above. The compositions of the present invention unexpectedly pass the UL 94HB flammability test required for such military devices without the use of a flame retardant additive.

The compositions of the present invention contain an acrylated urethane oligomer in which there is an average of from 2 to 3 inclusive acrylate or methacrylate groups, these urethane oligomers are based on aliphatic isocyanate. The aliphatic isocyanates are preferably diisocyanates including 1,6-hexamethylene diisocyanate, 1,4-hexamethylene diisocyanate, 2,2,4-trimethylhexamethylene diisocyanate, 2,4,4-trimethyl-hexamethylene diisocyanate, 4,4'-methylene-bis(cyclohexyl)-isocyanate, isophorone diisocyanate and 1-methyl-2,4-diiso-cyanatocyclohexane. For applications which do not require clear to opaque materials, aromatic isocyanates can be used in making acrylated urethane oligomers. These aromatic containing acrylated urethane oligomers can be utilized where the property profiles are similar to those materials based on aliphatic isocyanate. Aromatic containing acrylated urethane oligomers will tend to yellow and discolor over time upon subjection to long term outdoor weathering conditions. Because the aromatic containing acrylated urethane oligomers have these limitations, they are not preferred for use in this invention. The acrylated urethane oligomers are known in the art and those which are particularly useful in the present invention are those which are described in U.S. Patent No. 4,607,084, issued August 19, 1986.

The acrylated urethane oligomers can be blended, such as those of polyether diols and polyether triols. The acrylated urethane oligomers can also contain reactive solvents. Such reactive solvents include alkyl acrylates, alkyl methacrylates, alkoxyalkyl acrylates, alkoxylalkyl methacryalates, allyl acrylate, phenoxyethyl acrylate, cyclohexyl acrylate, acrylonitrile, cyanoethyl acrylate, 1,6-hexanediol diacrylate, trimethylolpropane triacrylate, acrylated fatty alcohols and acrylated aliphatic diglycidyl ethers. A preferred reactive solvent is ethoxyethoxyethyl acrylate which is in amounts of from 10 to 12 parts by weight based on 100 parts by weight of the acrylated urethane oligomer. The reactive solvent can be present in amounts of from 0 to 50 weight percent based on the total weight of the acrylated urethane oligomer. Preferably, if the reactive solvent is present, it is present in an amount of from about 10 to about 20 weight percent.

The compositions of the present invention include, per 100 parts by weight of (A), 50 to 60 parts by weight of hydroxy-propylmethacrylate of (B).

The compositions of the present invention contain hydroxymethylphenylpropanone as the photoinitiator to provide the ultraviolet radiation curable property. The photoinitiator is used in amounts of from 3.0 to 3.5 parts by weight and which are suitable to provide cure of the composition when it is exposed to ultraviolet radiation. This amount of hydroxymethylphenylpropanone cures the composition completely enough so that oily substances do not leach from the cured material onto the surrounding substrate which is both electronically undesirable and unattractive or the amount of the substances which leaches out is very small and does not interfere with future processing. The inventors believe that the completeness of the cure may play a role in the adhesion of the cured composition to substrates and to the other properties of the cured material.

The present compositions of this invention contain from 1.9 to 2.1 parts by weight of 1,1-bis(t-butylperoxy)-cyclohexane which is an amount sufficient to provide cure when the composition is exposed to heat after the composition is cured by exposure to ultraviolet radiation. The compositions will also cure by heating alone. This organic peroxide is one which remains stable in the uncured composition, which cures upon heating and which does not produce acidic by-products that can cause corrosion to electronic materials. The compositions are shelf stable at ambient temperatures when packaged in a single container.

The compositions of this invention are thixotropic because 11 to 12 parts of amorphous silica filler is added. The silica filler has a surface area from 150 to 300 square meters per gram. A particularly useful silica is fumed silica. The required thixotropy for the composition is such that it can be dispensed from a orifice to the use area and deposited with low force and that it will flow, but only, to the extent that it will not flow into a hole of 1.27 mm (0.05 inch) in diameter to a depth of more than 0.51 mm (0.02 inch). The composition preferably has a viscosity of from 30,000 to 100,000 centipoise measured with a Brookfield Model HATD viscometer using a number 3 spindle, at 0.5 revolutions per minute. The compositions of the present invention must be of sufficiently low viscosity to fill the voids between contact tails and their individual cavities without penetrating too deeply into the connector insulator holes. Thus, the composition must be thixotropic with the capability of being dispensed from a small nozzle and then quickly reverting to a highly viscous material which will not flow to any substantial degree before it cures.

The connector pin hole adhesion as used in this application relates to adhesion whether mechanical or chemical is satisfactory when the cured film allows for processing with degreasing solvents without it delaminating and the connector pin holes remained sealed. These pin holes are of such size as described above, for example, about 1.27 mm (0.05 inch) in diameter.

The compositions of the present invention may contain other ingredients such as fungicides or colorants which includes fluorescent dyes and visible light organic dyes, as long as these materials do not add to the corrosive nature of the composition or deleteriously effect the electrical and other physical properties of the uncured composition or the cured product. Small amounts of ingredient may be useful to change the crosslink density of the compositions of this invention and include the di-, tri-, tetra-, penta- and hexa-functional acrylates and methacrylates. Inhibitors may be present in the composition to keep it stable during storage. These storage inhibitors may be found in the acrylated urethane oligomer or the hydroxypropylmethacrylate. Their amounts in these ingredients are usually sufficient to allow storage stabilities such that the compositions of this invention will remain usable for more than one year. Examples of such inhibitors are 4-methoxyphenol and phenothiazine.

The composition of this invention is one which will not corrode the electronic components it contacts either in the uncured or cured state. The composition is sufficiently neutral and must not contain ingredients which may change this neutrality. A change in neutrality results in a composition which may cause corrosion to materials used in electronic components. For example, the composition of the present invention should not contain amines, such as the tertiary organic amines which are often used as co-initiators with photosensitizers, because these amines cause corrosion to metal substrates found in the electronic components. Also acidic materials should not be used in the compositions of the present invention because these materials also cause corrosion.

The compositions of the present invention are particularly useful in coating and encapsulating military electronic components, for example, where they can be used as backfill for electronic connectors which contain at least one connector pin hole. Such coatings typically have thicknesses of 0.64-2.54 mm (25 to 100 mils). Such electronic components are found on printed wire boards (printed circuit boards).

The compositions of this invention can be cured by exposure to ultraviolet radiation and thereafter can be heated to cure any portion of the coating or encapsulant which did not receive ultraviolet radiation. Such heating will cause the composition to cure in the dark regions (regions not receiving ultraviolet radiation exposure) and thus the compositions of this invention have the ability to shadow cure. These compositions have solvent resistance to such solvents as xylene, acetone, isopropanol, methyl ethyl ketone, Freons and urethane thinners. The cured compositions of this invention exhibit connector pin hole adhesion to poly(phenylene)sulfide material used as a substrate to make electronic boards. Similar adhesion is observed to substrates such as metal, glass and other plastic substrates, such as metal leads and plastic connector materials. Coating materials such as parylene will adhere to the cured composition. As stated, the compositions are sufficiently thixotropic to be applied and then stay in place until they are cured. The compositions are non-corrosive before, during and after cure, where cure includes both the ultraviolet cure and the post heat cure. The compositions have the ability to withstand thermal shock from -65°C. to 120°C. The compositions of this invention when cured sufficiently exhibit a low weight loss upon subjecting to hot or cold degreasing solvent. The compositions exhibit acceptable electrical properties for use as insulative coatings and encapsulants for electronic components, such as volume resistivity and dielectric withstanding voltage. The composition of the present invention exhibits sufficient fungus resistance without the addition of additional fungicides, but in certain applications it may be advantageous to add to this fungus resistance. If additional fungicide is needed, careful evaluation of the fungicide should be conducted to determine its effect on other properties, such as corrosion. The compositions also exhibit humidity resistance and resistance to soldering heat. The above properties are needed to provide a composition which will be useful for backfilling electronic connectors where the coating will come in contact with the delicate materials which are used in the electronic components of printed wire boards.

The following examples are presented for illustrative purposes and should not be construed as limiting the invention which is properly delineated in the claims. In the following examples, "part" or "parts" represents "part by weight" or "parts by weight."

4

Example 1

COMPOSITION A

A composition was prepared by combining the following ingredients:

111.1 parts of an acrylated urethane oligomer mixture having 100 parts of acrylated urethane oligomer and 11.1 parts of ethoxyethoxyethyl acrylate, the mixture having a viscosity of 9,800 cps at 65°C., a specific gravity of 1.05 and an isocyanate content of less than 0.2 percent, the acrylated urethane oligomer is based on an aliphatic isocyanate and is sold by Radcure Specialties, Inc. of Atlanta, Georgia as Ebecryl 8800 UV/EB Curable Resin,

54.1 parts of hydroxypropylmethacrylate and about 0.02 part of 4-methoxyphenol,

3.38 parts of hydroxymethyl phenylpropanone,

2.52 parts of 1,1-bis(t-butylperoxy) cyclohexane which is 2.02 parts of peroxide in 0.5 part of butyl benzyl phthalate and is sold by Witco Chemical, Richmond, California as USP-400P,

11.3 parts of fumed silica filler having a specific surface area of 200 square meters per gram.

COMPARATIVE COMPOSITION A

A composition was prepared by combining the following ingredients:

111.8 parts of an acrylated urethane oligomer mixture having 100 parts of acrylated urethane oligomer and 11.8 parts of ethoxyethoxyethyl acrylate, the mixture having a viscosity of 9,800 cps at 65°C., a specific gravity of 1.05 and an isocyanate content of less than 0.2 percent, the acrylated urethane oligomer is based on an aliphatic isocyanate and is sold by Radcure Specialties, Inc. of Atlanta, Georgia as Ebecryl 8800 UV/EB Curable Resin,

54 parts of hydroxypropylmethacrylate and about 0.02 part of 4-methoxyphenol,

3.35 parts of hydroxymethyl phenylpropanone,

2.56 parts of 1,1-bis(t-butylperoxy) cyclohexane which is 1.92 parts of peroxide in 0.64 part of butyl benzyl phthalate and is sold by Witco Chemical, Richmond, California as USP-400P,

28.6 parts of trixylenol phosphate, sold as Kronitex TXP by FMC Corporation, Philadelphia, PA and

11.3 parts of fumed silica filler having a specific surface area of 200 square meters per gram.

COMPARATIVE COMPOSITION B

A composition was prepared by combining the following ingredients:

111.8 parts of an acrylated urethane oligomer mixture having 100 parts of acrylated urethane oligomer and 11.8 parts of ethoxyethoxyethyl acrylate, the mixture having a viscosity of 9,800 cps at 65°C., a specific gravity of 1.05 and an isocyanate content of less than 0.2 percent, the acrylated urethane oligomer is based on an aliphatic isocyanate and is sold by Radcure Specialties, Inc. of Atlanta, Georgia as Ebecryl 8800 UV/EB Curable Resin,

54.9 parts of hydroxypropylmethacrylate and about 0.02 part of 4-methoxyphenol,

3.92 parts of hydroxymethyl phenylpropanone,

1.96 parts of 1,1-bis(t-butylperoxy) cyclohexane which is 1.57 parts of peroxide in 0.39 part of butyl benzyl phthalate and is sold by Witco Chemical, Richmond, California as USP-400P,

11.8 parts of fumed silica filler having a specific surface area of 200 square meters per gram.

9.8 parts of 1,2-bis(trimethoxysilyl)ethane.

The above compositions were prepared by warming the acrylated urethane oligomer, the hydroxypropylmethacrylate and the silica filler to 60°C. and blending. The other ingredients were then added and blended into the resulting mixture with one pass on a 3-roll mill. Composition A was a colorless material having a Brookfield Model HATD viscosity of 43,600 cps using a No. 3 spindle at 0.5 rpm. Comparative Composition A had a Brookfield Model HATD viscosity of 85,000 cps using a No. 3 spindle at 0.5 rpm. Comparative Composition B was a colorless material having a Brookfield Model HATD viscosity of 3,600,000 cps using a No. 6 spindle at 0.5 rpm.

The compositions were coated on poly(phenylene)sulfide substrates and cured by exposing the coated substrate to a medium pressure mercury lamp having an output of 200 watts per linear inch. Substrates with film thicknesses of 0.84 mm (33 mil) and 3.05 mm (120 mil) were tested by the UL 94HB test. Each coated substrate was cured by placing the coated surface one inch below the mercury lamp for 10 seconds and then heating for 10 minutes at 93.3°C (200°F). The combined burn time and glow time in seconds were observed and were as shown in Table I.

## TABLE I

| THICKNESS | 0,84mm (33 MIL) THICKNESS | | 3,05mm (120 MIL) | |
|---|---|---|---|---|
| COMPOSITION | FIRST BURN | SECOND BURN | FIRST BURN | SECOND BURN |
| A | - - | - - | 0 | 2 |
| COMPARATIVE A | 43 | 19 | 0 | 3 |
| COMPARATIVE B | 78 | 82 | 0 | 193 |

The solvent resistance of coated substrates as prepared above were evaluated by measure the weight loss after subjecting the coated substrates to degreasing solvents according to the schedule 10 minutes of Freon TMC vapor, 10 minutes of boiling Freon TMC liquid and 10 minutes of Freon TMC vapor and then heating in an air circulating oven at 70°C. for 72 hours before calculating the weight loss. The coated substrates were also heated for 72 hours at 70°C. without being exposed to the degreasing solvents. Table II shows the results of the weight loss for each of the coated substrates.

TABLE II

| COMPOSITION | NO SOLVENT EXPOSURE WEIGHT LOSS, % | SOLVENT EXPOSED WEIGHT LOSS |
|---|---|---|
| A | 2.1 | 0.4 |
| COMPARATIVE A | 2.9 | 14.7* |
| COMPARATIVE B | 3.4 | 1.6 |

*Some weight loss was contributed to pieces of film which delaminated and cracked because the material was poor quality.

Solvent resistance was also evaluated by coating glass slides with 1.27 mm (50 mil) wet thickness of each composition and then curing by exposing them to 2.5 joules per square centimeter. All the cured coated surfaces were tack-free. Each coated substrate was exposed for 10 minutes to Freon TA vapor. Another set of coated substrates were exposed for 10 minutes to Freon TMC. Another set of coated substrates were exposed for 10 minutes to 1,1,1-trichloroethane. The appearance of the coated substrates after the solvent exposure was observed and the weight loss percentage was measured. The results were as shown in Table III.

TABLE III

| SOLVENT | COMPOSITION | APPEARANCE | WEIGHT LOSS, % |
|---|---|---|---|
| FREON TA | A | NO DELAMINATION VERY SLIGHT RESIDUE** | 1.3 |
| | COMPARATIVE A | NO DELAMINATION RESIDUE | 2.9 |
| | COMPARATIVE B | NO DELAMINATION VERY SLIGHT RESIDUE | 2.6 |
| FREON TMC | A | NO DELAMINATION SOME RESIDUE | 0.85 |
| | COMPARATIVE A | EDGE DELAMINATION RESIDUE | 4.5 |
| | COMPARATIVE B | EDGE DELAMINATION RESIDUE | 2.2 |
| TRICHLORO-ETHANE | A | NO DELAMINATION VERY SLIGHT RESIDUE | 0.87 |
| | COMPARATIVE A | EDGE DELAMINATION RESIDUE | 5.4 |
| | COMPARATIVE B | EDGE DELAMINATION SOME RESIDUE | 1.6 |

**Residue was the material around the periphery of the cured coating leached out by the solvent during the degreasing process and remained after the solvent evaporated.

Composition A and Comparative Composition B were coated on poly(phenylene)sulfide test coupons at 1.27 mm (50 mil) wet thickness and cured at 91.4 cm (3 feet) per minutes on an LCU to provide 1.5 joules per square centimeter and then the coated test coupons were coated with parylene. Composition A adhered well to both the board and the parylene interfaces whereas Comparative Composition B did not adhere to the parylene interface. Boards with parylene were exposed to an autoclave for 30 minutes at 270°C. without exhibiting any failure whereas Comparative Composition B under the same conditions failed.

Composition A was coated on a substrate to provide a 1.27 mm (50 mil) wet thickness and heated at 100°C. for 10 minutes. The resulting film was completely cured whereas Comparative Composition B was only partially cured under the same conditions.

Each of the above compositions were coated on poly(phenylene)sulfide copper mirror substrate with a 1.27 mm (50 mil) wet coat and then cured for 91.4 cm (3 feet) per minute, about 2 J/cm$^2$ on an LCU, manufactured by UVEXS, Inc. of Mountainview, California, U.S.A., and then aged for 16 hours at room temperature. The dielectric withstanding voltage test per Mil-I-46058 was done at 1500 volts for each of the compositions. Composition A had a dielectric withstanding voltage of 2 x 10$^{-9}$ amp, Comparative Composition A had a dielectric withstanding voltage of 3 x 10$^{-9}$ amp and Comparative Composition B had a dielectric withstanding voltage of 1.1 x 10$^{-9}$ amp.

**Claims**

1. An ultraviolet curable composition consisting essentially of
   (A) 100 parts by weight of an acrylated urethane oligomer containing an average of from 2 to 3 acryl groups selected from the group consisting of acrylate and methacrylate, said acrylated urethane oligomer being based on aliphatic isocyanate,
   (B) 50 to 60 parts by weight of hydroxypropylmethacrylate,
   (C) 3.0 to 3.5 parts by weight of hydroxymethylphenyl-propanone,
   (D) 1.9 to 2.1 parts by weight of 1,1-bis(t-butylperoxy)-cyclohexane, and
   (E) 11 to 12 parts by weight of amorphous silica filler having a surface area of from 150 to 300 square meters per gram.

2. The composition according to claim 1 in which there is also present ethoxyethoxyethylacrylate in an amount of from 10 to 12 parts by weight.

3. An article comprising a low leaching cured composition obtained by exposing the composition of claim 1 to ultraviolet radiation in sufficient intensity and duration to cure the composition.

4. The article according to claim 3 further comprising a substrate and the low leaching cured composition having a low weight loss in degreasing solvent, which composition adheres to the substrate both before and after hot or cold degreasing solvent exposure and passes the UL 94HB test.

5. The article according to claim 4 in which the substrate is an electrical connector device having at least one connector pin hole.

**Patentansprüche**

1. Zusammensetzung, die durch ultraviolette Strahlung härtbar ist, im wesentlichen bestehend aus:
   (A) 100 Gewichtsanteilen eines Urethanoligomeren mit Acrylgruppen, das im Mittel 2 bis 3 Acrylgruppen, ausgewählt aus der Gruppe bestehend aus Acrylat und Methacrylat, enthält, wobei das Urethanoligomer mit Acrylgruppen auf aliphatischem Isocyanat basiert,
   (B) 50 bis 60 Gewichtsanteilen Hydroxylpropylmethacrylat,
   (C) 3,0 bis 3,5 Gewichtsanteilen Hydroxymethylphenylpropanon,
   (D) 1,9 bis 2,1 Gewichtsanteilen 1,1-Bis(t-butylperoxy)cyclohexan und
   (E) 11 bis 12 Gewichtsanteilen eines amorphen Siliciumdioxid-Füllstoffes mit einer Oberfläche von 150 bis 300 m$^2$ pro g.

2. Zusammensetzung gemäß Anspruch 1,
   **dadurch gekennzeichnet,**
   daß darin außerdem Ethoxyethoxyethylacrylat in einer Menge von 10 bis 12 Gewichtsteilen vorhanden ist.

3. Gegenstand, der eine nur schwer anlösbare gehärtete Zusammensetzung aufweist, die erhalten wird, indem die Zusammensetzung nach Anspruch 1 ultravioletter Strahlung in ausreichender Intensität und Dauer, um die Zusammensetzung zu härten, ausgesetzt wird.

4. Gegenstand gemäß Anspruch 3,
   **dadurch gekennzeichnet,**
   daß er außerdem einen Träger und die schwer anlösbare gehärtete Zusammensetzung mit einem geringen Gewichtsverlust in entfettendem Lösemittel aufweist, wobei die Zusammensetzung an dem Träger sowohl bevor als auch nachdem sie heißem oder kaltem entfettenden Lösemittel ausgesetzt wird, haftet und den UL 94HB-Test besteht.

5. Gegenstand gemäß Anspruch 4,
   **dadurch gekennzeichnet,**

daß der Träger ein elektrisches Anschlußteil mit mindestens einem Loch für einen Anschlußsteckerstift ist.

## Revendications

1. Une composition durcissable par ultraviolets constituée essentiellement :
   (A) de 100 parties en poids d'un oligomère uréthane acrylé comptant une moyenne de 2 à 3 groupes acryles choisis dans le groupe constitué par les groupes acrylate et méthacrylate, ledit oligomère uréthane acrylé étant à base d'isocyanate aliphatique,
   (B) de 50 à 60 parties en poids de méthacrylate d'hydroxypropyle,
   (C) de 3,0 à 3,5 parties en poids d'hydroxyméthylphénylpropanone,
   (D) de 1,9 à 2,1 parties en poids de 1,1-bis(t-butylperoxy)cyclohexane, et
   (E) de 11 à 12 parties en poids de charge de silice amorphe présentant une surface spécifique de 150 à 300 m$^2$/g.

2. La composition selon la revendication 1 dans laquelle est également présent de l'acrylate d'éthoxyéthoxyéthyle en une proportion de 10 à 12 parties en poids.

3. Un article comprenant une composition durcie à faibles fuites obtenue par exposition de la composition de la revendication 1 à des rayons ultraviolets sous une intensité et pendant une durée suffisantes pour faire durcir la composition.

4. L'article selon la revendication 3 comprenant en outre un substrat et la composition durcie à faibles fuites ayant une faible perte de poids dans un solvant dégraissant, ladite composition adhérant au substrat tant avant qu'après exposition au solvant dégraissant chaud ou froid et subissant avec succès l'essai UL 94HB.

5. L'article selon la revendication 4 dans lequel le substrat est un dispositif de connexion électrique comportant au moins un trou de broche de connexion.